## Europäisches Patentamt
## European Patent Office
## Office européen des brevets

(19)

(11) Veröffentlichungsnummer: **0 154 698**
**A2**

(12) **EUROPÄISCHE PATENTANMELDUNG**

(21) Anmeldenummer: **84115137.6**

(22) Anmeldetag: **11.12.84**

(51) Int. Cl.⁴: **H 03 H 9/64**

(30) Priorität: **29.02.84 DE 3407480**

(43) Veröffentlichungstag der Anmeldung: **18.09.85**
**Patentblatt 85/38**

(84) Benannte Vertragsstaaten: **AT BE CH DE FR GB IT LI NL SE**

(71) Anmelder: **Siemens Aktiengesellschaft, Berlin und München Wittelsbacherplatz 2, D-8000 München 2 (DE)**

(72) Erfinder: **Sprengel, Heinz-Peter, Dipl.-Phys., Lindum 8 1/2, D-8250 Dorfen (DE)**

(54) **Elektrisches Oberflächenwellenfilter.**

(57) Elektrisches Oberflächenwellenfilter mit einem piezoelektrischen Substratträger, der auf einer Oberseite einen Ein- und Ausgangswandler (14 bzw. 15) trägt, der jeweils über einen nach außen geführten Ein- und Ausgangsanschluß (22 bzw. 23) mit einer gedruckten Schaltung elektrisch kontaktierbar ist, und der mit seiner Rückseite auf einem Metallträger (11, 12) befestigt ist, der einstückig angeformte Masseanschlüsse (20) aufweist, wobei zur Vermeidung des elektrischen Übersprechens der Ein- und/oder Ausgangsanschluß (22 bzw. 23) symmetrisch zu diesem Anschluß ausgerichtete Masseanschlüsse (20) aufweist.

Siemens Aktiengesellschaft
Berlin und München

0154698

Unser Zeichen
VPA 84 P 1179 E

Elektrisches Oberflächenwellenfilter

Die Erfindung betrifft ein Oberflächenwellenfilter gemäß Oberbegriff des Patentanspruches 1.

Oberflächenwellenfilter sind z.B. durch das Datenbuch "Oberflächenwellen-Filter LIOB", Ausgabe 1983/84, Herausgeber Siemens, bekannt. Sie stellen integrierte, passive Bauelemente mit Bandfiltercharakteristik dar, deren Funktion auf der Interferenz von mechanischen Oberflächenwellen beruht.
Ihr Aufbau ist durch ein einkristallines, piezoelektrisches Substrat, insbesondere aus Lithiumniobat, gekennzeichnet, auf das eine Aluminiumschicht aufgedampft ist, aus der mittels Photoätztechnik piezoelektrische Ein= und Ausgangswandler herausgearbeitet sind. Das Substrat selbst ist auf einen Metallträger aufgeklebt. Die Kontaktierung der Ein= und Ausgangswandler mit den nach außen führenden Anschlüssen erfolgt dabei über Bonddrähte.

Im Betrieb wird ein in den Eingangswandler eingegebenes Signal in eine mechanische Oberflächenwelle umgewandelt, die auf bzw. in der Oberfläche des Substrats zum Ausgangswandler läuft, der die Oberflächenwelle schließlich wieder in ein elektrisches Signal umwandelt. Die üblicherweise verwendeten Wandler sind Interdigitalstrukturen mit Laufzeiteffekten, die mit einer Struktur zur Abschirmung versehen sein können. Sie haben stark frequenzabhängige Eigenschaften, so daß aufgrund der Ausbildung der Strukturen eine Filterwirkung für elektrische Signale erreichbar ist.

Kra 1 RM / 23.10.1984

0154698

Die an sich sehr guten Filtereigenschaften dieser Oberflächenwellenfilter werden durch sog. Übersprechen verschlechtert. Dabei handelt es sich um einen durch zu starke elektromagnetische Verkopplung der Ein- und Ausgangsanschlüsse verursachten Signalübergang vom Ein= zum Ausgang, der den filternden Eigenschaften des Filters nicht unterliegt. Insbesondere bei hochfrequenten Signalen, mit Frequenzen $>$ 100 MHz, nimmt speziell die induktive Komponente sehr stark zu, so daß die derzeit verwendeten Kunststoffgehäuse für diese Filter nur bedingt einsetzbar sind.

Die durch diese Nachteile verursachten mangelhaften HF-Eigenschaften der Kunststoffgehäuse erfordern die Verwendung teuerer, in ihrer Montage und Fertigung aufwendiger Metallgehäuse oder zusätzliche Maßnahmen, wie Symmetrieübertrager, Abschirmbleche und Kompensationen auf der Schaltungsplatine.

Die Aufgabe der vorliegenden Erfindung ist es, eine Maßnahme zur Verringerung des elektrischen Übersprechens bei Oberflächenwellenfiltern der vorstehend genannten Art anzugeben, die den problemlosen Einsatz insbesondere von Kunststoffgehäusen für diese Filter gestattet.

Zur Lösung dieser Aufgabe sieht die Erfindung bei einem elektrischen Oberflächenwellenfilter der gemäß Oberbegriff des Patentanspruches 1 angegebenen Art vor, daß zur Vermeidung des elektrischen Übersprechens die Masseanschlüsse symmetrisch zu den Ein= und/oder Ausgangsanschlüssen angeordnet sind.

Die Erfindung wird nachstehend anhand von Ausführungsbeispielen näher erläutert. Es zeigt:

Fig. 1 in schematischer und teilweise vereinfachter Darstellung eine Draufsicht auf ein erstes Ausführungsbeispiel eines Oberflächenwellenfilters nach der
Erfindung, bei dem nur ein Teil des aus mehreren
Teilen zusammengesetzten Kunststoffgehäuses angedeutet ist.

Fig. 2 in schematischer und teilweise gebrochener Darstellung eine Draufsicht auf ein zweites Ausführungsbeispiel des Gegenstandes nach der Erfindung, bei dem nur der Metallträger samt Anschlüssen und der elektrisch aktive OFW-Teil gezeigt ist.

Fig. 3 in teilweise gebrochener und geschnittener Ansicht ein drittes Ausführungsbeispiel eines
Oberflächenwellenfilters nach der Erfindung.


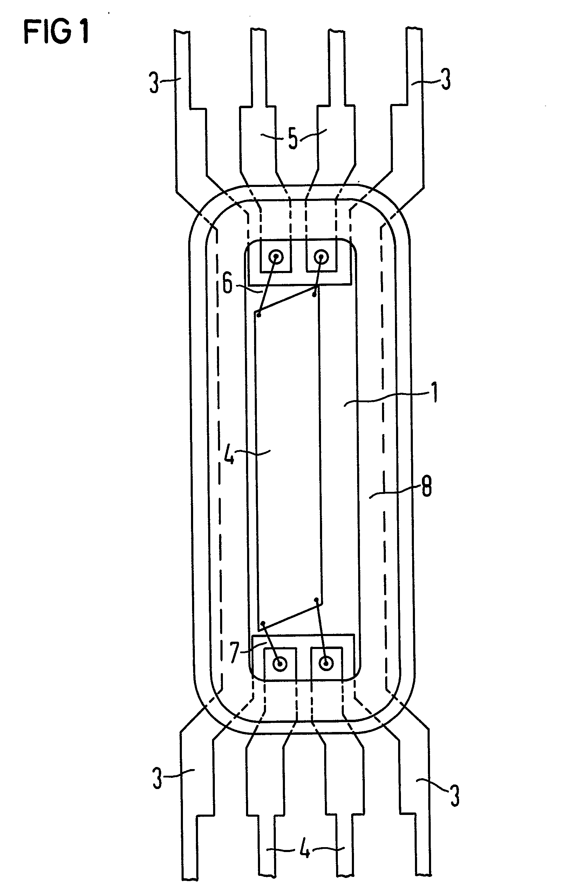

In Fig. 1 ist mit 1 der z.B. aus Cu-Fe-Blech ausgestanzte
Metallträger für einen auf diesen Metallträger aufgeklebten Oberflächenwellenfilter-Chip 2 bezeichnet. Die in
der Figur zur Vereinfachung nicht dargestellten Eingangs=
und Ausgangswandler dieses Oberflächenwellenfilters liegen
über Bonddrahtkontaktierungen 6, 7 an Ein= bzw. Ausgangsanschlüssen 4 bzw. 5, die zweckmäßigerweise gleichfalls aus
dem für den Metallträger verwendeten Cu-Fe-Blech ausgestanzt sind. Symmetrisch zu diesen Ein= und Ausgangsanschlüssen sind Masseanschlüsse 3 bzw. Massebeine ausgerichtet, die an den Metallträger 1 einstückig angeformt
oder gegebenenfalls angeschweißt sind.
Die Masseanschlüsse 3 wirken in Verbindung mit der Masse
der in der Zeichnung nicht dargestellten Schaltungsplatine
als Kurzschlußschleife. Die in den Masseanschlüssen induzierten Ströme reduzieren die durch die Ein= und Ausgangsströme erzeugten Felder und verringern dadurch die Verkopplung von Ein= und Ausgang 4, 5. Darüberhinaus werden die vom Oberflächenwellenfilter-Chip 2 über den Metallträger 1 und die Masseanschlüsse 3 zur Schaltungsplatine fließenden Ströme symmetrisch aufgeteilt, wodurch gleichfalls eine Einkopplung der Eingangsspannung in den Ausgangskreis unterbunden wird.

Fig. 1 zeigt lediglich eine Wanne 8 aus duroplastischem Werkstoff als Teil des Kunststoffgehäuses. Diese Wanne liegt gegen die Unterseite des Metallträgers 1 an und sitzt mit ihrer Seitenwandung 6 auf den Randflächen der Trägeroberseite des Metallträgers 1 auf, so daß der Metallträger 1 und sämtliche Anschlüsse in der Wanne 8 fest fixiert sind.

Über diese Wanne ist ein nicht dargestellter wannenförmiger Deckel aus duroplastischem Werkstoff gestülpt und die gesamte Anordnung, bestehend aus der Wanne 8 samt zugehörigem Deckel mit einer gleichfalls nicht dargestellten Umhüllung aus duroplastischem Werkstoff umpreßt.

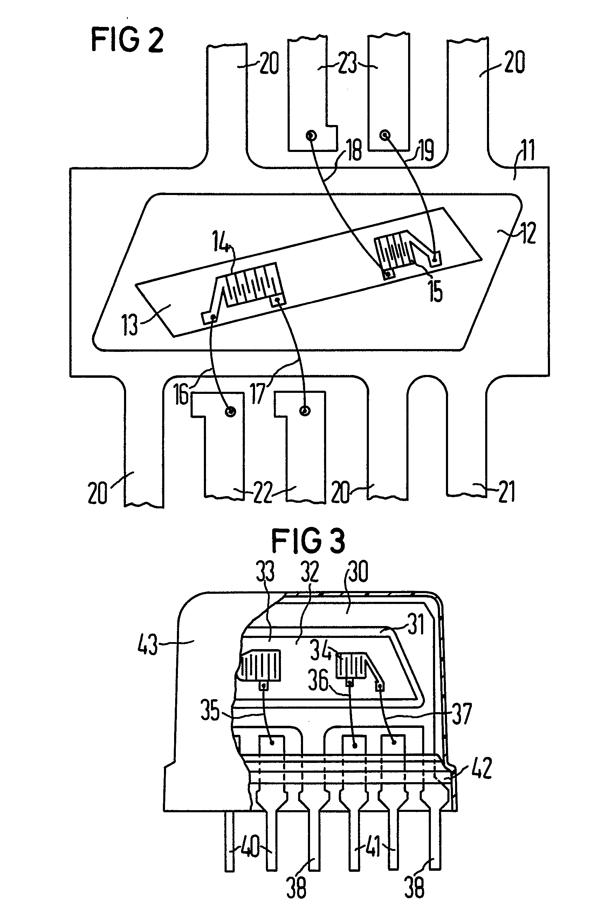

Beim Ausführungsbeispiel nach Fig. 2 besitzt der Metallträger 11 einen abgesenken Teil 12, auf den ein Oberflächenwellenfilter-Chip 13 aufgeklebt ist. Die Ein= und Ausgangswandler 14, 15 sind mittels Bonddrahtkontaktierungen 16, 17 bzw. 18, 19 mit Ein= bzw. Ausgangsanschlüssen 22 bzw. 23 kontaktiert. Symmetrisch zu diesen Anschlüssen sind Masseanschlüsse 20 bzw. Massebeine angeordnet, die mit dem Metallträger 11 insbesondere einstückig verbunden sind. drehsicheren Einsatz dieses Oberflächenwellenfilters in gedruckte Schaltungen weist der Metallträger 11 ein zusätzliches Massebein 21 auf.

Beim Ausführungsbeispiel nach Fig. 3 sind lediglich zum Ausgangsanschluß 41 symmetrisch ausgerichtete Masseanschlüsse 38 vorgesehen. Das Filter selbst besteht wiederum aus einem Metallträger 30, auf dessen abgesenken Teil 31 ein Oberflächenwellenfilter-Chip 32 aufgeklebt ist. Die Ein= und Ausgangswandler 33, 34 des Chips sind über Bonddraht- kontaktierungen 35 bzw. 36, 37 mit den Ein= und Ausgangsanschlüssen 40 bzw. 41 kontaktiert.

Die Beine sämtlicher Anschlüsse sind i.ü. mit einem Sockel 42 aus duroplastischem Material umpreßt, auf dem eine Kunststoffkappe 43 aufsitzt.

0154698

## Patentansprüche

1. Elektrisches Oberflächenwellenfilter mit einem piezoelektrischen Substratkörper, der auf seiner Oberseite einen Ein= und Ausgangswandler trägt, der jeweils über einen oder mehrere nach außen geführte Ein= und Ausgangsschlüsse mit einer gedruckten Schaltung elektrisch kontaktierbar ist, und der mit seiner Rückseite auf einem Metallträger befestigt ist, der Masseanschlüsse aufweist, d a d u r c h g e k e n n z e i c h n e t, daß zur Vermeidung des elektrischen Übersprechens die Masseanschlüsse (3 bzw. 20 bzw. 38) symmetrisch zu den Ein= und/oder Ausgangsanschlüssen (4, 5 bzw. 22, 23 bzw. 40, 41) angeordnet sind.

2. Oberflächenwellenfilter nach Anspruch 1, d a d u r c h g e k e n n z e i c h n e t, daß zum verdrehsicheren Einsatz des Oberflächenwellenfilters in gedruckte Schaltungen der Metallträger (11) einen zusätzlichen Masseanschluß (21) aufweist.

3. Oberflächenwellenfilter nach Anspruch 1 und 2, d a d u r c h g e k e n n z e i c h n e t, daß die Masseanschlüsse (3 bzw. 20 bzw. 38) einstückig mit dem Metallträger (11) verbunden sind.

4. Oberflächenwellenfilter nach Anspruch 1 bis 3, g e k e n n z e i c h n e t durch die Verwendung für Oberflächenwellenfilter mit Kunststoffgehäuse (43).

FIG 1

FIG 2

FIG 3